Europäisches Patentamt

European Patent Office

Office européen des brevets

(11) Numéro de publication: **0014119**
**A1**

## (12) DEMANDE DE BREVET EUROPEEN

(21) Numéro de dépôt: 80400039.6

(51) Int. Cl.³: **H 05 K 13/02**

(22) Date de dépôt: **11.01.80**

(30) Priorité: **12.01.79 FR 7900780**

(43) Date de publication de la demande: 06.08.80
**Bulletin 80/16**

(84) Etats contractants désignés: **AT BE CH DE GB IT LU NL SE**

(71) Demandeur: **SOCIETE D'ETUDES RECHERCHES ET CONSTRUCTIONS ELECTRONIQUES SERCEL, Avenue du Bel Air Zone Industrielle, F-44470 Carquefou (FR)**

(72) Inventeur: **Angelle, Philippe Albert, Le Fayau, Treillieres F-44215 La Chapelle/Erdre (FR)**
Inventeur: **Bodin, Jacques, Le Corleveau, Basse Goulaine 44 (FR)**
Inventeur: **Basset, Raymond, 9, rue Maurice Chevalier, F-44 Nantes (FR)**
Inventeur: **Lacorre, Jean-Baptiste, L'Ouche-Arnaud, Laloue Haute Goulaine 44 (FR)**
Inventeur: **Romeuf, Jean, Bernard, Marie, La Grassiniere, F-44 Vertou (FR)**

(74) Mandataire: **Corre, Jacques et al, Cabinet Regimbeau 26, Avenue Kléber, F-75116 Paris (FR)**

(54) **Positionnement de microcomposants, notamment pour les circuits à couches épaisses ou à couches minces.**

(57) L'invention concerne la fabrication de circuits électroniques utilisant des microcomposants.

Des parcs de microcomposants sont formés à l'aide de matrices 10 comportant en partie supérieure une pluralité de logements identiques 12, et en partie inférieure une plaque 15 portant un codage numérique qui définit un code d'orientation de la matrice et un code de composant. Ce genre de parc à microcomposants est utilisable dans différentes machines de manipulation de microcomposants, en mode automatique ou semi-automatique.

Application notamment à la fabrication de circuits à couches minces ou à couches épaisses.

## Positionnement de microcomposants, notamment pour les circuits à couches épaisses ou à couches minces

L'invention concerne la fabrication des circuits électroniques. On connaît les technologies de réalisation de tels circuits par sérigraphie (couches épaisses) ou à l'aide d'un dépôt sous vide (couches minces). Dans les deux cas, on réalise sur un substrat généralement en alumine des dépôts de conducteurs, de résistances, de selfs ou de condensateurs. Il est ensuite nécessaire de reporter sur ce substrat dans une position précise les microcomposants actifs (transistors, diodes, circuits intégrés) ainsi que certains microcomposants passifs (résistances, condensateurs, selfs), dont les valeurs ou les précisions ne sont pas réalisables avec les technologies couches minces ou couches épaisses. Il est manifestement souhaitable que ce report de microcomposants actifs ou passifs soit effectué automatiquement.

Des solutions ont déjà été proposées à cet effet. Elles ne donnent pas entière satisfaction, principalement parce qu'elles sont limitées à certains types de circuits électroniques à fabriquer -circuits logiques- et/ou parce qu'elles supposent des investissements considérables justifiables seulement pour des fabrications de très grandes séries.

La présente invention propose une installation pour positionner les microcomposants électroniques, ainsi que pour les transférer ou manipuler. Cette installation s'articule autour de moyens nouveaux, qui permettent de réaliser différents types de machines propres à réaliser l'ensemble des opérations relatives à la fabrication d'un circuit électronique donné.

Selon une première caractéristique de la présente invention, chaque machine comporte un parc de microcomposants, et des moyens logiques de commande ; le parc de microcomposants est agencé pour admettre en position de travail prédéterminée au moins une matrice qui comporte en partie supérieure une pluralité de logements identiques répartis en lignes et colonnes suivant un réseau matriciel régulier de pas connu, et qui comporte en partie inférieure un codage numérique lequel définit un code d'orientation de la matrice et un code de composant ; le parc de microcomposants comporte, sous la position de travail prédéterminée, un lecteur de ce code, relié aux moyens logiques de commande. Dans cette disposition, la matrice définit spatialement la position ainsi que le type des microcomposants qu'elle contient, et son code inférieur permet aux moyens logiques de commande de connaître ces deux informations, et d'assister ainsi le transfert de microcomposants, notamment en calculant les coordonnées des différents logements de la matrice.

Selon une caractéristique avantageuse de l'invention, le parc de microcomposants comprend un support rotatif capable de tourner par pas angulaire prédéterminé, et susceptible de recevoir un plateau circulaire porte-matrices qui comporte en périphérie des alvéoles répartis suivant ce pas angulaire et dimensionnés pour loger exactement une ou plusieurs matrices; le fond des alvéoles permet l'accès au codage de chaque matrice, tandis que le lecteur de code est disposé sous le plateau au droit de l'une des positions d'alvéole, qui définit la position de travail.

Selon une autre caractéristique avantageuse de l'invention, les matrices sont de deux tailles différentes, choisies pour que chaque alvéole du plateau puisse loger une seule matrice ou bien quatre matrices orientables en sens différent sur deux directions orthogonales ; le codage inférieur des matrices est lisible indifféremment selon ces quatre orientations, sauf pour le code d'orientation lui-même.

Dans certaines des machines de l'installation, l'organe de transfert de microcomposants comprend un chariot de transfert à mouvement commandé selon deux directions horizontales, et sur ce chariot un équipage susceptible d'un léger pivotement vertical et muni d'un bras terminé par une buse d'aspiration dirigée vers le bas, qui est soumise à un déplacement vertical lorsque le bras pivote, ce qui permet de soulever un microcomposant de sa position initiale, de l'amener à la verticale d'une position finale, et de l'y déposer en conservant son orientation ; les moyens de commande sont capables de commander le mouvement du chariot de transfert pour faire varier séquentiellement l'une des positions initiale et finale de son mouvement en fonction du pas matriciel, de manière que cette position puisse correspondre successivement aux différents logements de la matrice.

Dans un mode de réalisation préférentiel de l'invention, le bras est rotatif selon un pas angulaire choisi sous l'effet d'un moteur porté par l'équipage mobile ; il est muni à son extrémité de plusieurs buses de diamètre différent, réparties selon le même pas angulaire, buses dont seule celle dirigée vers le bas est soumise à aspiration.

Ces moyens de base sont susceptibles de se combiner pour définir plusieurs machines destinées d'une part à charger les microcomposants en position prédéterminée dans les matrices, d'une autre part à préparer un ensemble de microcomposants destinés à la réalisation d'un circuit électronique donné, d'autre part enfin à déposer les microcomposants sur le substrat à couches minces ou à couches épaisses correspondant à ce circuit électronique.

D'autres caractéristiques et avantages de l'invention apparaîtront à la lecture de la description détaillée qui va suivre, faite en référence aux dessins annexés, donnés à titre d'exemple non limitatifs, et sur lesquels :

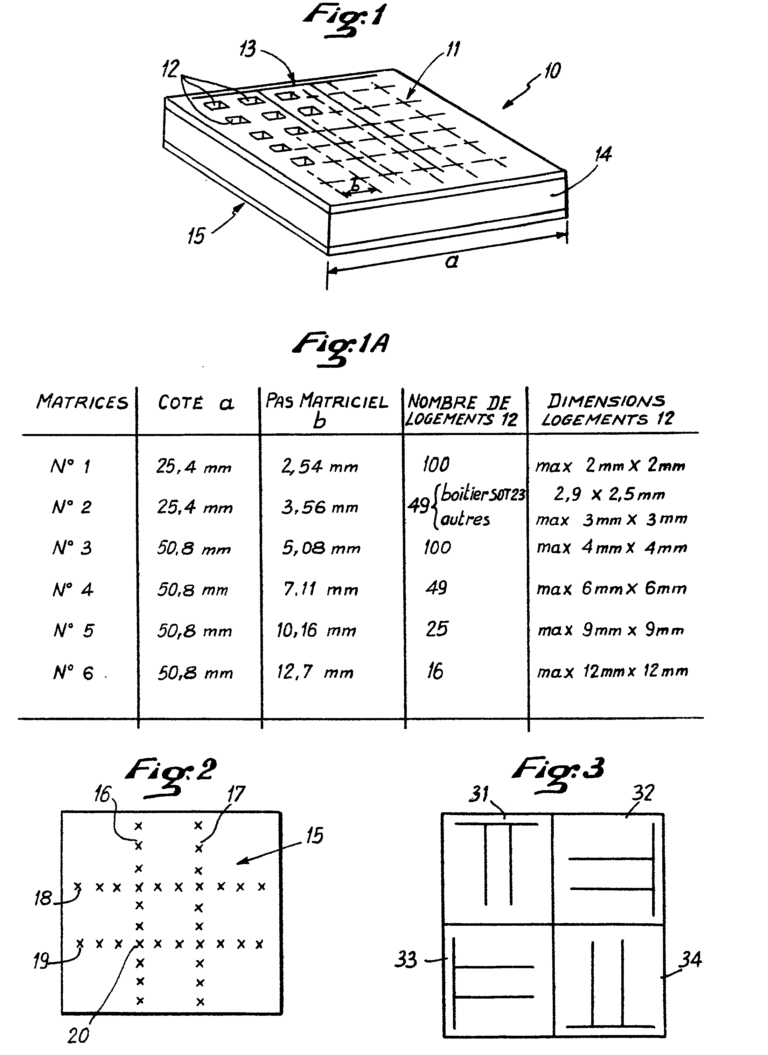

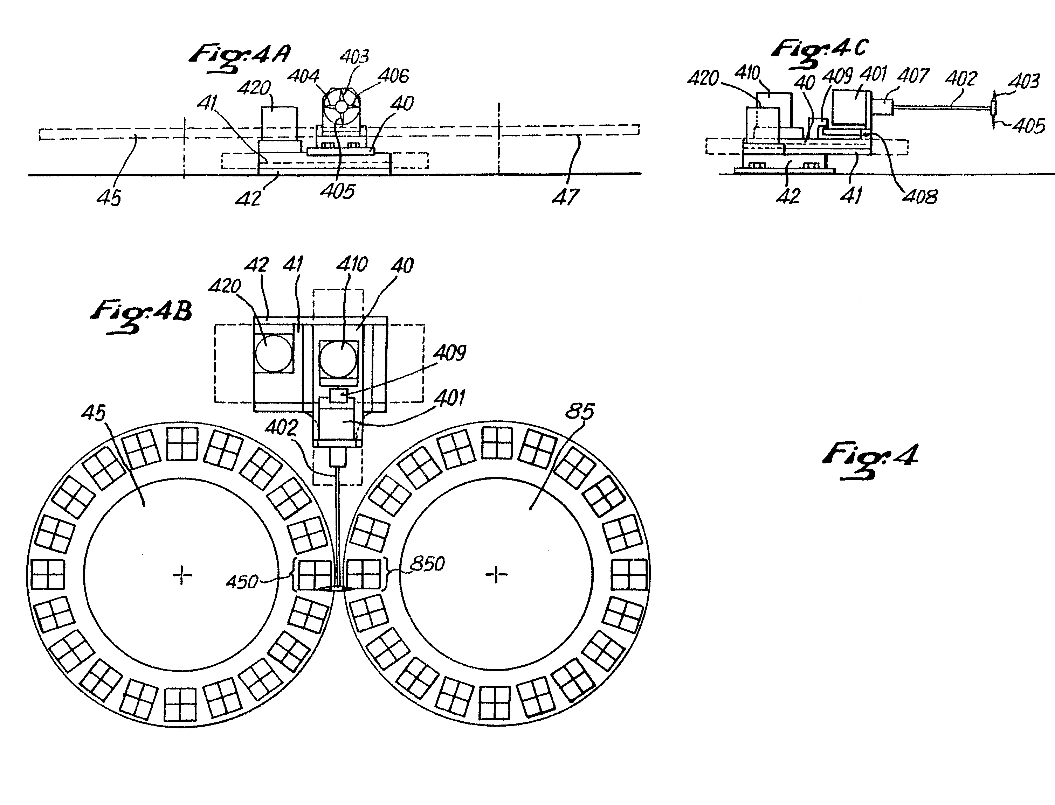

. La Figure 1 est une vue en perspective cavalière d'une matrice à microcomposants selon la présente invention, la Figure 1A étant un tableau illustrant différentes configurations matricielles, tandis que la Figure 2 illustre un exemple préférentiel de réalisation du code en partie inférieure 15 de la matrice de la Figure 1, et que la Figure 3 illustre comment l'on peut disposer quatre matrices de pas moitié selon quatre orientations différentes :

. Les Figures 4A à 4C, constituant ensemble la Figure 4, illustrent le fonctionnement de l'organe de transfert utilisé dans certaines machines de la présente invention ;

. La Figure 5 illustre schématiquement une pre mière machine permettant le chargement en matrice de microcomposants moulés ou en microboîtiers ;

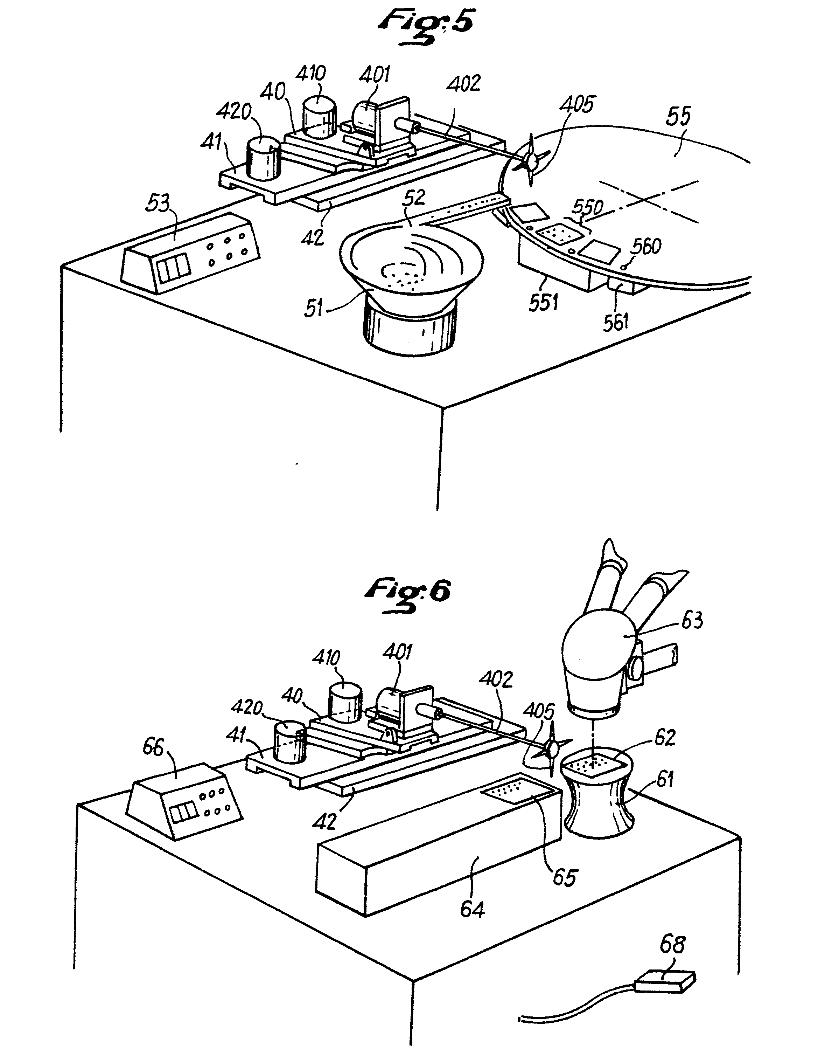

. La Figure 6 illustre schématiquement une seconde machine permettant le chargement en matrice des puces de diodes, transistors ou circuits intégrés ;

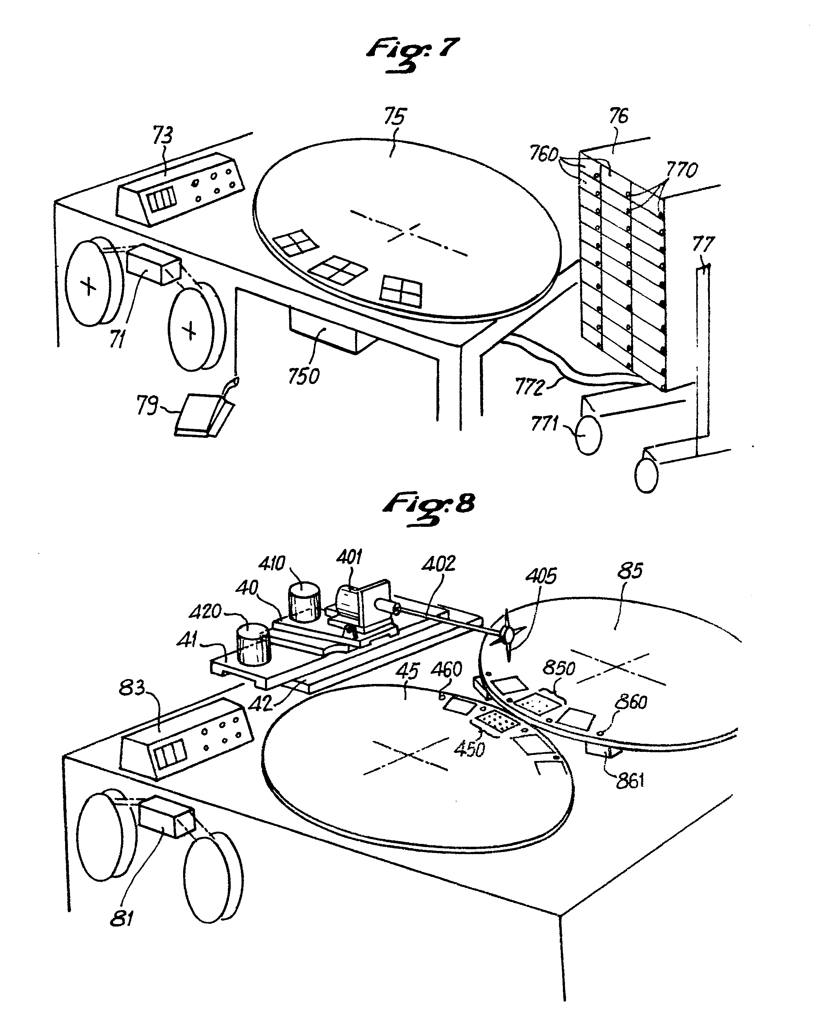

. La Figure 7 illustre une troisième machine permettant la préparation d'un plateau porte-matrices en vue de réaliser un circuit électronique donné ; et

. La Figure 8 illustre une quatrième machine permettant le dépôt des microcomposants sur les substrats, en vue de réaliser les circuits électroniques complets.

Les Figures 1 à 3 concernent les matrices qui constituent l'un des éléments de base de l'invention, en permettant de former des "parcs" de microcomposants rangés. Sur la Figure 1, la matrice 10 comporte une grille métallique supérieure 11, un intercalaire 14, plastique ou métallique, et une plaque d'identification et d'orientation inférieure 15. La grille 11 définit avec une grande précision (de l'ordre de quelques centièmes de millimètres) une pluralité de logements 12, réalisés par exemple par photogravure. La grille 11 porte en outre un repère d'orientation visuel 13, constitué par exemple de la lettre $\pi$ stylisée. L'intercalaire 14 est choisi d'épaisseur suffisante pour permettre de loger les composants les plus hauts , et il comporte des logements correspondant à chacune des ouvertures 12. Enfin, la plaque inférieure 15 comporte des indications codées relatives à l'identification du genre de composants disposés dans la matrice, ainsi qu'à leur orientation. Le codage de la plaque d'identification peut également être réalisé par photogravure, ou bien, en variante, à l'aide d'un adhésif noir mat perforé et collé sur une surface métallique polie. Comme le montre la Figure 2, chaque plaque inférieure 15 comporte avantageusement quatre répétitions du même code désignées par 16 à 19. Ces répétitions sont arrangées de manière symétrique par rapport au centre de la plaque, qui est carrée. Toutefois, les codes placés au croisement, tel que le code 20, ne seront pas symétriques, de manière à définir l'indication d'orientation. Tout comme la face inférieure 15, la plaque supérieure 11 est elle aussi réalisée sous forme d'agencement symétrique par rapport au centre. Ainsi, les logements identiques tels que 12 sont répartis en lignes et colonnes suivant un réseau matriciel régulier de pas connu . La Figure 1A illustre six formats de matrices différentes utilisables avantageusement selon l'invention. En choisissant convenablement les dimensions du logement 12, ces différentes configurations de base permettent de constituer des parcs de la plupart des microcomposants utilisés en fabrication. Les indications du tableau de la Figure 1A sont à considérer comme incorporées à la présente description, à titre d'application préférentielle.

On remarque sur le tableau de la Figure 1A que les matrices numéros 1 et 2 ont un côté a égal à la moitié de celui des autres matrices. Elles peuvent alors être disposées en carré selon quatre orientations différentes, comme l'indique la Figure 3, pour les matrices 31 à 34.

L'application préférentielle de l'invention consiste à disposer des matrices du type qui vient d'être décrit dans des alvéoles de dimensions 50,8 mm X 50,8 mm un alvéole contenant donc soit une seule matrice, soit quatre matrices, qui peuvent alors être disposés comme le montre la Figure 3. Dans cette application, le fond des alvéoles est bien entendu prévu pour permettre l'accès au codage inférieur de chaque matrice ; dans une réalisation préférentielle, le fond des alvéoles est transparent, et la lecture du codage s'effectue par des moyens photoélectriques à réflexion.

Très avantageusement, le support des matrices est un plateau circulaire 45, qui comporte en périphérie des alvéoles aux dimensions 50,8 mm x 50,8 mm, répartis suivant un pas augulaire préétabli. (Figure 4B). Le lecteur de code est disposé sous le plateau au droit de l'une des positions d'alvéoles, ici la position 450.

Certaines au moins des machines formant l'installation de la présente invention comportent un organe de transfert de microcomposants, que l'on décrira maintenant en référence aux trois vues de la Figure 4.

Sur un bâti 42 est disposé un chariot de transfert à mouvement commandé selon deux directions horizontales. Ce chariot comporte une platine inférieure 41, mobile sur le bâti 42 sous l'action d'un moteur pas à pas 420. A son tour, le chariot inférieur 41 supporte un chariot supérieur 40, mobile dans la direction orthogonale sous l'effet d'un moteur pas à pas 410. Enfin, le chariot supérieur 40 est muni d'un support de pivotement 408 sur lequel est monté un équipage mobile comportant un moteur 401, un joint 407, et une tige 402 entraînée par le moteur, et portant à son extrémité quatre buses d'aspiration 403 à 406. Le pivotement de cet équipage est limité par une butée 409. Un micro-vérin à air comprimé, non représenté, permet de solliciter l'ensemble de l'équipage mobile de façon à relever l'extrémité de la tige 402.

Dans la tige 402 passe quatre petits tubes d'alimentation en vide des buses 403 à 406 ; ces quatre tubes sont reliés par le collecteur tournant 407 à une alimentation sous-vide, de telle manière que seule la buse dirigée vers le bas, ici 405, soit soumise à aspiration. Le moteur pas à pas 401 est commandé de manière à assurer une sélection de celle des buses 403 à 406 dont les dimensions conviennent aux micro-composarts concernés. Le pivotement du bras 402 est choisi de manière qu'il permette un déplacement vertical d'environ 10 mm au niveau de la buse, pour la prise du composant, son chargement en matrices, sa reprise
dans une matrice ainsi que son report sur un substrat.
Enfin, les moteurs pas à pas 410 et 420 assurent le
déplacement de la buse en X-Y dans un plan horizontal,
avec un pas de 0,064 mm, et une course maximum de
120 mm. Avantageusement, le collecteur tournant 407
est alimenté par une servo-valve électrique non représentée, qui permet donc de commander l'aspiration par
la buse 405. Il est également prévu un disque métallique portant une mince fente et monté sur le collecteur
tournant ; en coopération avec un lecteur photoélectrique, il permet de remettre à zéro le moteur pas à pas
de commande de buse après un arrêt de marche de la
machine. De leur côté, les deux chariots 40 et 41 coulissent à angle droit sur des rails à billes ; et leurs
mouvements sont contrôlés par les moteurs pas à pas par
l'intermédiaire d'un entraînement effectué par courroie
crantée ou par vis et écrou. Deux interrupteurs de
haute précision, par exemple le modèle MY-COM vendu
par la Société suisse ELESTA, permettent d'effectuer
une remise à zéro automatique des deux chariots 40 et
41.

Le reste de la Figure 4, et en particulier le plateau 85, concerne l'application à la quatrième machine
selon l'invention, qui l'on décrira plus loin.

Dans l'installation selon l'invention, la première
phase est le chargement en matrices des microcomposants. A cet effet, l'installation utilise une ou
plusieurs machines comprenant un dispositif de présentation (51, 52 figure 5 ; 61, 62, 63 Figure 6),
apte à délivrer des microcomposants dans une orientation prédéterminée au voisinage d'une matrice placée
en position de travail ; il est prévu un organe d'entrée d'information (53 Figure 5 ; 66 Figure 6) pour
communiquer à des moyens logiques de commande incorporés

0014119

à la machine au moins un code de pas de la matrice et un code de composants ; les moyens logiques de la machine contrôlent d'abord l'orientation de la matrice présente en position de travail à partir de son code inférieur, ainsi que la correspondance entre son code de microcomposants et celui qui est défini par l'organe d'entrée ; ensuite, la logique de la machine commande le mouvement du chariot de transfert et de son équipage mobile suivant un nombre d'étape égal au nombre de composants que peut contenir la matrice ; chaque étape comporte la prise d'un microcomposant en sortie du dispositif de présentation, et sa dépose finale dans un logement de la matrice ; enfin, une nouvelle position finale de dépose du microcomposant est à chaque fois calculée compte tenu du pas matriciel.

Deux machines de ce genre, un peut différentes, sont illustrées sur les Figures 5 et 6. La machine de la Figure 5 est destinée principalement au chargement en matrices des composants moulés ou en microboîtiers, généralement des boîtiers dits SOT23 pour les composants actifs. Après avoir subi un contrôle, les microcomposants sont mis en vrac au fond d'un bol vibrant 51. Sous l'action des vibrations en rotation, les composants montent sur une rampe hélicoïdale, et sont triés par un piège spécialisé, avant d'arriver dans une position déterminée vers une goulotte de sortie 52. A la sortie de cette goulotte, les microcomposants sont pris en charge par l'organe de transfert ou robot qui a déjà été décrit à propos de la Figure 4. Dans cette application, la buse 405 prend les microcomposants dans une position prédéterminée et suivant une orientation déterminée en sortie de la goulotte 52, pour les porter successivement dans les différents logements de la matrice présente dans la position de

0014119

travail 550. On notera sur la Figure 5 le contrôleur du code inférieur de la matrice 551, ainsi qu'un dispositif 561 qui coopère avec des alésages 560 placés dans le disque porte-matrices 55, de manière à définir l'indexation de la rotation de celle-ci, avec la précision désirée.

Avantageusement, l'organe d'entrée 53, ou pupitre de commande, permet à l'opérateur de sélectionner non seulement le pas de la matrice (par exemple de 1/50e de pouce) et le code de composants, à 4 chiffres décimaux, mais aussi un code de buses, qui définit celle des buses 403 à 406 devant être utilisée, ainsi que les coordonnées du premier composant de la matrice. Ces coordonnées de premier composant suffisent à caractériser le remplissage de la matrice, dans la mesure où celles-ci sont toujours remplies et vidées de la même façon. On peut ainsi remplir une matrice qui n'aurait été déjà que partiellement vidée.

En coopération avec le lecteur de code 551, les moyens logiques de commande, qui comportent avantageusement un microprocesseur, contrôlent que le code de la matrice en place sur la position de travail 550 correspond bien au code de composants présélectionnés par l'opérateur sur le pupitre 53 ; est également contrôlée l'orientation de la matrice dans la position de travail 550. Cette machine est capable de charger les matrices à la cadence de 1500 à 3000 composants à l'heure.

La seconde machine, illustrée à la Figure 6, est plus particulièrement destinée au chargement en matrices des puces (chips) de circuit intégré.

Bien qu'elle puisse utiliser un plateau rotatif comme la machine de la Figure 5, celle de la Figure 6 est équipée dans le cas présent d'un support 64 muni d'un seul alvéole enfermant exactement une matrice 65, ou bien quatre matrices de dimension moitié.

Le dispositif de présentation est dans ce second cas constitué d'un véhicule 61 orientable manuellement, et muni en partie supérieure d'un réceptacle 62 apte à recevoir une pluralité de puces de circuit intégré. Le véhicule 61 est par exemple un plot dont la partie inférieure aimantée vient se fixer sur la table supérieure de la machine. En faisant tourner ce plot 61, l'opérateur peut l'orienter dans n'importe quelle direction. Il s'y ajoute un moyen optique 63 constitué d'une loupe binoculaire à réticule, qui permet à l'opérateur d'une part de contrôler visuellement chaque puce, et d'autre part de l'orienter et de le positionner avec précision par rapport au réticule. Après cela, l'opérateur actionne la pédale 68, et le robot amène la buse 405 pour venir prendre la puce située au droit du réticule , et l'amener dans la matrice 65, dans les positions successivement calculées compte tenu du pas de celles-ci. Pour le reste, la machine de la Figure 6 est semblable à la précédente. On notera simplement la nécessité que le microscope binoculaire 63 ait une distance frontale d'observation suffisante pour permettre le passage des buses 405.

La Figure 7 illustre une troisième machine, dépourvue d'organe de transfert, et servant au chargement et au déchargement en matrices des plateaux circulaires porte-matrices. On notera que les deux premières machines permettent de remplir les matrices à l'aide de microcomposants. Ces matrices sont alors rangées dans un meuble de stockage 76, supporté par un bâti 77 et des roulettes 71. Dans ce meuble, l'un des tiroirs 760 correspond à des matrices comprenant un type de composant bien déterminé. Il est associé à chaque tiroir un petit circuit logique qui allume un voyant tel que 770. En variante, le circuit logique peut également actionner le verrouillage/déverrouillage du tiroir. A titre d'exemple, un meuble de dimensions 350 x 550 x 280 mm peut comprendre 50 rangées de trois tiroirs chacune, tandis que chaque tiroir peut recevoir dix matrices de grand format, ou bien 40 matrices de format moitié.

On notera d'ailleurs, que le meuble de stockage peut être relié directement aux première et seconde machines, auquel cas celles-ci excitent l'un des voyants de tiroir à partir du code composant sélectionné par l'opérateur sur le pupitre de commande, d'où l'indication immédiate du tiroir où il faut ranger la matrice qui vient d'être remplie de composants.

La troisième machine comporte un lecteur de ruban perforé de commande 71, un pupitre de visualisation et de contrôle 73, un support de plateau tournant porte-matrices 75, avec un dispositif d'avance pas à pas et un lecteur de code photoélectrique 750 semblables à ceux de la Figure 5. Enfin, le meuble de stockage précité 76 est raccordé électriquement à la machine par un cordon 772 et une prise amovible non représentée.

Le plateau tournant 75 peut être monté et démonté très rapidement de la machine ; il comporte en périphérie 20 cases de dimensions très précises 50,8 mm x 50,8 mm, repérées par des lettres A à T. Un moteur électrique, non représenté, le fait tourner de 1/20e de tour sur commande de la pédale 79.

La fonction première de la machine de la Figure 7 est la suivante : les moyens logiques de commande (non représentés) sont agencés pour établir une correspondance entre un casier tel que 760 défini par les moyens de désignations tels que 770 et le code présenté par la matrice en position de travail, lu par le lecteur de code 750. Ces moyens logiques assistent alors l'opérateur pour transférer une matrice entre un plateau porte-matrices et le magasin de stockage à casiers. On retrouve ici la fonction de comparaison qui peut s'appliquer non seulement à la machine de la Figure 7, mais aussi à celle des Figures 5 et 6, comme précédemment indiqué.

La machine de la Figure 7 comporte en outre une fonction permettant de préparer des plateaux porte-matrices à l'aide de l'ensemble des microcomposants qui sont nécessaires pour la fabrication d'un circuit électronique donné. A cet effet, le ruban perforé de commande appliqué au lecteur 71 comporte une succession de blocs d'informations, à raison d'un bloc d'informations par matrice à monter dans les alvéoles du plateau 75. Chaque bloc d'informations présente la constitution suivante :

- caractère n° 1, lettre choisie entre A et T et définissant l'un des alvéoles de composants du plateau 75 ;

- caractère n° 2, numéro de matrice, à savoir 1, 2, 3 et 4 suivant qu'il s'agit d'une matrice de petit format présente dans l'un des quatre quadrants de l'alvéole, ou encore 0 s'il s'agit d'une matrice de grand format ;

- caractère n° 3, orientation de la matrice (A, B, C, D) correspondant à 0°, 90°, 180° et 270° ;

- caractères n° 4 à n° 7, code de composant incluant quatre caractères décimaux ; et

- caractère n° 8, fin de bloc.

En réponse à l'actionnement de la pédale 79 par l'opérateur, la machine va tourner d'1/20e de tour ou non, suivant que le numéro de matrice est 4 et 0 ou bien 1, 2 et 3.

De son côté, le pupitre de visualisation 73 reproduit avantageusement les information de la bande

0014119

perforée pour permettre un contrôle par l'opérateur.

En réponse au code de composant, la logique de commande allume en premier lieu le voyant du tiroir correspondant du meuble de stockage. L'opérateur ouvre alors ce tiroir y prélève une matrice et la met en position sur le plateau porte-matrices 75. Après cela, la logique de commande contrôle que la matrice ainsi disposée a été mise en place correctement dans l'alvéole du plateau 75, non seulement quant à sa position dans l'un des quatre quadrants s'il s'agit d'une matrice de petit format, mais aussi sur le plan de son orientation. Après un nouveau coup de pédale de l'opérateur et une rotation éventuelle du plateau porte-matrices 75; les mêmes opérations sont répétées jusqu'à remplissage complet de ce plateau.

Ceci effectué, le plateau porte-matrices 75 sera avantageusement utilisé dans la quatrième machine que l'on décrira plus loin.

En variante, la troisième machine peut également servir au déchargement de matrices vides ou partiellement pleines après leur passage sur la quatrième machine. Dans ce mode de déchargement, on n'utilise pas la bande perforée, mais simplement la correspondance entre le code composant de la matrice présente sur le plateau 75 et les tiroirs du meuble 76. Après avoir lu un code composant sur la matrice, les moyens logiques allument le voyant du tiroir correspondant, ce qui permet à l'opérateur de reprendre la matrice sur le plateau et de la reloger dans le tiroir adéquat. Comme précédemment, les opérations se suivent à raison d'un actionnement de la pédale à chaque fois, et le plateau se tournera d'1/20e de tour après lecture d'un numéro de matrice égal à 4 ou 0, pour tenir compte du fait que les matrices peuvent avoir la grande taille ou le format moitié.

La quatrième machine de l'installation selon
l'invention est importante, et sera décrite    maintenant en référence aux Figures 4 et 8. Cette machine
a pour fonction d'assurer le transfert automatique des
microcomposants sur les substrats à partir d'un plateau porte-matrices  déjà chargé compte tenu des
besoins en microcomposant du substrat. La machine
comporte :

   - un lecteur de ruban perforé 81 ;
   - un pupitre de visualisation et de contrôle 83 ;
   - un robot ou organe de transfert portant les
buses telles que 405, semblable à ceux qui ont déjà été
décrits ;
   - deux supports de plateaux tournants 45 et 85,
·le support 45 étant un plateau porte-matrices déjà
chargé sur une machine telle que celle ·de la Figure 7,
et le plateau 85 étant un plateau porte-substrats.

   Chacun des supports de plateaux tournants possède
un dispositif d'avance pas à pas par 1/20e de tour, et
également un dispositif électromécanique d'indexation
de haute précision, par exemple à. alésage 860 et
tige guide 861, pour positionner les plateaux avec
précision au moment où les microcomposants sont transférés. Comme sur la machine de la Figure 7, le support
de plateau porte-matrices possède un système de contrôle photoélectrique assurant le contrôle du code et
de l'orientation de la matrice présente dans la position de travail 450. De son côté, le support de plateau
substrat 85 a un simple contrôle photoélectrique de
présence d'un substrat dans la case sélectionnée 850.

   Tous les substrats d'un même plateau doivent en
principe recevoir les mêmes composants car ils correspondent à un même type de circuit. On notera que les
substrats, qu'il s'agisse de circuits à couches minces
ou de circuits à couches épaisses comportent déjà en eux-mêmes un certain nombre de fonctions qui ont pu être réalisées suivant ces technologies et que l'apport de microcomposants n'a pour but que de leur ajouter des éléments non susceptibles d'être réalisés à l'aide des technologies de base.

Le lecteur de ruban perforé 81 sert de mémoire d'instructions, et comporte une pluralité de blocs d'informations relatifs chacun à un composant, et non plus à une matrice comme c'était le cas pour la Figure 7.

Ainsi, un bloc d'informations pour un composant comporte avantageusement les caractères suivants :

- caractère n° 1, une lettre définissant un logement du plateau porte-matrices (les lettres A à T précitées, qui correspondent aux chiffres 1 à 20 en ne prenant que les cinq derniers bits à droite du code bien connu ASCII) ;

- caractère n° 2, numéro de la matrice dans le logement désigné, le code étant 1, 2, 3, 4, ou bien 0, comme précédemment ;

- caractère n° 3, orientation de la matrice, le code étant A, B, C ou D comme précédemment ;

- caractère n° 4, pas de la matrice en 1/50e de pouce ; avantageusement ce code peut être exprimé par les lettres E, G, J, N, T, et Y, qui correspondent à 5, 7, 10, 14, 20, 25 en ne prenant que les cinq derniers bits à droite du code ASCII ;

- caractère n° 5, code de buse (1, 2, 3, 4, lorsqu'il y a quatre buses) ;

- caractères n° 6, n° 7, n° 8, n° 9, code de composant définit comme précédemment par quatre chiffres décimaux ;

- caractères n° 10 à n° 13, coordonée X sur le substrat, exprimée avec un pas de 2,5/1000e de pouce, soit 63,5 microns ;

- caractère n° 14 à n° 17, coordonée Y sur le substrat, exprimée avec un pas égal à 63,5 microns ;

- caractère n° 18, exprimant diverses indications, notamment que le substrat en question nécessite un ou deux plateaux de composants pour être complètement équipés (indications 0 X ou 1 X, X désignant que le second chiffre est indifférent), le même caractère peut encore exprimer le fait que le composant doit être passé dans l'araldite avant d'être appliqué sur le substrat, ce qui utilise alors le deuxième chiffre (X1 s'il faut passer dans l'araldite ou X0 dans le cas contraire). A titre d'exemple, lorsqu'il faut deux plateaux porte-matrices et que le composant doit être passé dans la colle, le caractère n° 18 exprimera en binaire par 11 soit 3 en décimal ; et

- caractère n° 19, fin de bloc.

En l'état actuel de la technologie, on monte un maximum de 60 composants sur un substrat dont les dimensions sont 50, 8 mm x 50,8 mm ; la bande perforée comprendra donc alors un maximum de 60 blocs de 19 caractères chacun.

La mémoire interne de la logique de commande qui va enregistrer ces informations aura une capacité de 2 x 1024 x 8 bits ce qui permet d'aller jusqu'à plus de 100 composants par substrat, et satisfait donc largement les besoins ci-cessus.

Comme pour la machine de la Figure 7, le pupitre de visualisation 83 indique à l'opérateur les informations correspondant à l'opération de transfert de microcomposants en cours ; ce pupitre est principalement utilisé pour la maintenance, dans la mesure où le fonctionnement de la machine est entièrement automatique. L'organe de transfert lui-même a déjà été décrit précédemment.

Le plateau de composants 45 chargé en matrices sur la troisième machine, comporte 20 cases pouvant chacune recevoir une matrice de 50,8 mm x 50,8 mm, ou bien 4 matrices de dimension moitié, qui sont alors orientables dans chacune des orientations possibles (0°, 90°, 180°, 270°).

Le contrôle photoélectrique réalisé à l'aide du lecteur de code placé sous la position de travail 450 permet de vérifier pour chacune de ces matrices que le code de composant et l'orientation de la matrice sont corrects.

De son côté, le plateau porte-substrats 85 possède 20 cases de dimensions 50,8 mm x 50,8 mm. Un système à ressort positionne chaque substrat par rapport à deux arêtes de référence. Comme précédemment indiqué, un contrôle photoélectrique détecte la présence ou l'absence d'un substrat dans la position de travail 850.

La logique de commande de la machine de la Figure 8 comprend principalement :

- la mémoire de programme déjà mentionnée, constituée de deux circuits intégrés de 1024 x 8 bits ;

- un microprocesseur qui est par exemple du type 6800 vendu par MOTOROLA ; et

- une mémoire de position composant dans les matrices.

Cette dernière mémoire comprend 5 octets par bac, soit 100 octets au total. Chaque octet correspond à deux nombres décimaux variant de 1 à 10, indiquant dans chaque matrice du plateau porte-matrices 45 et à chaque instant le numéro de ligne et le numéro de colonne où il faut aller chercher le composant à reporter sur le substrat.

Pour chaque composant, l'adresse de la mémoire où il faudra aller chercher ces indications d'emplacement pourra donc être calculée par le microprocesseur suivant la formule suivante :

Adresse = [Numéro de bac (1 à 20) - 1] x 5 + Numéro de matrice.

Le numéro de logement dans le plateau porte-matrices ainsi que le numéro de la matrice sont lus dans la mémoire de commande remplie initialement à partir du ruban perforé.

Le format de la mémoire de "position composant" sera le suivant :

Pour le logement A de la matrice, la mémoire comporte tout d'abord l'adresse 00, qui définit le cas où le numéro de la matrice est 0, c'est-à-dire où elle est de grand format, ainsi qu'un numéro de ligne et un numéro de colonne définissant l'état de remplissage de la matrice, ou en d'autres termes l'endroit du premier composant que l'on pourra y prélever ; toujours pour le logement A, 4 autres valeurs de l'adresse (01 à 04) sont prévues pour correspondre au cas où il s'agit d'une matrice de dimension moitié prévue dans l'un des 4 quadrants de l'alvéole du plateau porte-matrices ; à chacune de ces adresses sont associés comme précédemment un numéro de ligne et un numéro de colonne.

Le remplissage de la matrice se complète de la même manière pour le logement B du plateau porte-matrices 45, avec à nouveau 5 valeurs différentes de l'adresse qui sont variables de 05 à 09. Il en est de même, ainsi de suite, pour tous les logements du plateau porte-matrices jusqu'au logement T.

Bien entendu, le contenu de cette mémoire de position de composants est modifié chaque fois qu'un composant est transféré du plateau porte-matrices 45 sur le substrat, de manière à vider les matrices dans un ordre régulier.

Le point de départ du mouvement de la buse 405 est calculé en fonction du numéro de logement dans le porte-matrices, défini par l'une des lettres A à T, du numéro de la matrice qui définit sa position dans le logement, ainsi que de la valeur des lignes et des colonnes et du pas de la matrice en question.

Le point final de transfert du microcomposants par la buse 405 est calculé d'après les coordonnées X et Y du point de report sur le substrat, qui sont définies dans la mémoire à partir du lecteur de ruban perforé.

On a vu précédemment que le caractère n° 18 du bloc d'informations indique si le report nécessite l'usage de plus d'un plateau de composants, et si le composant doit être trempé dans un bain d'araldite situé en un point fixe intermédiaire, avant d'être reporté sur le substrat. Il est tout à fait accessible à l'homme de l'art de prévoir le mouvement du robot portecomposants de manière à faire tremper le composant dans un bain d'araldite.

Le mode de travail de cette machine est le suivant ;

a) mise en place par l'opérateur d'un plateau de composants et d'un plateau de substrats, les deux plateaux étant mis à zéro automatiquement d'après des repaires fixes ;

b) mise en place du ruban perforé de commande et mise en mémoire de son contenu dans la mémoire de programme ;

c) ensuite, le plateau de substrats reste fixe pendant le déroulement du programme de report de composants. A la fin de ce programme, le premier substrat aura reçu tous ses composants, ou bien une première partie des composants dont il a besoin s'il est prévu deux plateaux de composants ;

d) le plateau de substrats effectue alors 1/20e de tour et le cycle de report recommande pour le deuxième substrat ;

e) l'opération se poursuit automatiquement jusqu'au vingtième substrat ou jusqu'à une case dé - tectée comme vide par le système photoélectrique, dans le cas où le travail se fait sur une série de moins de 20 substrats.

La cadence de travail est de 1 composant toutes les 1 ou 2 secondes.

La demanderesse a observé que certains composants sont soumis à des tolérances de fabrication très larges, pour lesquelles il faudra donc prévoir des logements de matrices égaux à la valeur maximale de la dimension en question. Lorsque certains composants de la série atteignent la valeur minimale, leur position peut être insuffisamment définie par leur placement dans la matrice, et on pourrait alors arriver à des microcomposants qui soient positionnés de manière incorrecte sur le substrat, ou du moins qui ne contactent que l'une des électrodes auxquelles ils doivent être soudés. En pareil cas, on utilisera avantageusement le centrage automatique de microcomposants décrit dans la demande de brevet n° 78 30 894 du 31 octobre 1978 au nom de la demanderesse. Sans entrer dans les détails de cette demande de brevet antérieure, on rappellera simplement que celle-ci décrit un moyen de centrage utilisant simplement une mise en vibration d'un composant placé dans un logement, par exemple à l'aide d'une buse, et qu'au terme de cette mise en vibration, le composant se trouve centré par rapport au logement avec une bonne précision.

Dans le cas de la machine de la Figure 8, il suffit donc de prévoir une amenée de la buse au-dessus du composant en question à la position de travail 450 du plateau porte-matrices. La buse est mise en contact avec le composant, l'aspiration étant excitée. La buse vibre alors de la manière décrite dans la demande de brevet précitée, après quoi le composant est centré par rapport à la buse, et cette buse peut poursuivre son mouvement comme précédemment pour amener le composant sur le substrat, sans risque maintenant d'avoir un mauvais positionnement final.

On notera que l'installation de la présente invention fournit 4 machines qui permettent de manière automatique ou semi-automatique l'ensemble des opérations requises pour transférer des microcomposants en position et selon une orientation prédéterminée sur un substrat de circuit à couches minces ou à couches épaisses, et ce sans limite aucune quant au type de composants, ni au type de circuit électronique à fabriquer à l'aide de substrats.

REVENDICATIONS

1. Installation pour positionner des microcomposants électroniques, caractérisée par le fait qu'elle comprend au moins une machine qui comporte un parc de microcomposants, et des moyens logiques de commande, par le fait que le parc de microcomposants est agencé pour admettre en position de travail prédéterminée au moins une matrice qui comporte en partie supérieure une pluralité de logements identiques répartis en lignes et colonnes suivant un réseau matriciel régulier de pas connu, et qui comporte en partie inférieure un codage numérique lequel définit un code d'orientation de la matrice et un code de composant, et par le fait que le parc de microcomposants comporte, sous la position de travail prédéterminée, un lecteur de ce code, relié au moyens logiques de commande.

2. Installation selon la revendication 1, caractérisée par le fait que le parc de microcomposants comprend un support rotatif capable de tourner par pas angulaires prédéterminés, et susceptible de recevoir un plateau circulaire porte-matrices qui comporte en périphérie des alvéoles répartis suivant ce pas angulaire et dimensionnés pour loger exactement une ou plusieurs matrices, le fond des alvéoles permettant l'accès au codage de chaque matrice, tandis que le lecteur de code est disposé sous le plateau au droit de l'une des positions d'alvéole.

3. Installation selon la revendication 2, caractérisée par le fait que les matrices sont de deux tailles différentes, choisies pour que chaque alvéole du plateau puisse loger une seule matrice ou quatre matrices orientables en sens différent sur deux directions orthogonales, et que le codage inférieur des matrices est lisible selon ces quatre orientations,
sauf pour le code d'orientation lui-même.

4. Installation selon l'une des revendications
1 à 3, caractérisée par le fait que la machine comporte un organe de transfert de microcomposants qui
comprend un chariot de transfert à mouvement commandé,
selon deux directions horizontales, et sur ce chariot
un équipage susceptible d'un léger pivotement vertical
et muni d'un bras terminé par une buse d'aspiration
dirigée vers le bas, qui est soumise à un déplacement
vertical lorsque le bras pivote, ce qui permet de
soulever un microcomposant de sa position initiale,
de l'amener à la vertical d'une position finale, et
de l'y déposer en conservant son orientation, et par
le fait que les moyens de commande sont capables de
commander le mouvement du chariot de transfert pour
faire varier séquentiellement l'une des positions
initiale et finale de son mouvement en fonction du
pas matriciel, de manière que cette position puisse
correspondre successivement aux différents logements
de la matrice.

5. Installation selon la revendication 4, caractérisée  par le fait que le bras est rotatif selon un
pas angulaire choisi sous l'effet d'un moteur porté
par l'équipage mobile, et qu'il est muni à son extrémité de plusieurs buses de diamètre différent, réparties selon le même pas angulaire, buses dont seule
celle dirigée vers le bas est soumise à aspiration.

6. Installation selon la revendication 4, caractérisée par le fait que la machine comporte un dispositif de présentation apte à délivrer des microcomposants dans une orientation prédéterminée au voisinage
de la position de travail, qu'il est prévu un organe
d'entrée d'informations pour communiquer aux moyens
logiques de commande au moins un code de pas de la matrice et un code de composant, et que ces moyens logiques contrôlent d'abord l'orientation de la matrice présente en position de travail sur le parc de microcomposants ainsi que la correspondance entre son code de microcomposant et le code de microcomposant défini par l'organe d'entrée, pour ensuite commander le mouvement du chariot de transfert et de son équipage mobile suivant un nombre d'étapes lié au pas matriciel, chaque étape comportant la prise d'un microcomposant en sortie du dispositif de présentation et sa dépose finale dans un logement de la matrice, et une nouvelle position finale de dépose étant à chaque fois calculée compte tenu du pas matriciel.

7. Installation selon la revendication 6, caractérisée par le fait que le dispositif de présentation est un bol vibreur muni d'un piège de sortie pour orienter les microcomposants, la machine étant destinée à mettre en matrice des composants moulés ou en microboîtiers.

8. Installation selon la revendication 6, caractérisée par le fait que le dispositif de présentation comporte un véhicule orientable manuellement, surmonté d'une optique à réticule permettant à un opérateur de positionner un microcomposant dans une orientation choisie à la verticale du réticule, que la machine comporte une pédale actionnée par l'opérateur lorsque ce positionnement est terminé, et que les moyens de commande effectuent chacune des étapes de transfert de microcomposants en réponse à l'actionnement de la pédale, cette machine étant destinée à mettre en matrice les puces de composants monolithiques.

9. Installation selon l'une des revendications 2 et 3, caractérisée par le fait que la machine comporte un magasin de stockage comportant d'une part une pluralité de casiers contenant chacun des matrices emplies d'un type de microcomposants associé au casier et d'autre part des moyens de désignation de casier reliés aux moyens logiques de commande, et par le fait que ces moyens logiques de commande sont agencés pour établir une correspondance entre un casier défini par les moyens de désignation et le code présenté par la matrice présente en position de travail sur le plateau circulaire porte-matrices, ce qui assiste l'opérateur pour transférer une matrice entre le plateau porte-matrices et le magasin de stockage à casiers, après quoi il actionne une pédale reliée au moyens logiques de commande.

10. Installation selon la revendication 9, caractérisée par le fait que la machine comporte aussi une mémoire de données d'instructions reliée au moyens logiques de commande, et apte à définir des blocs d'informations successifs comportant chacun une information d'index désignant un alvéole du plateau porte-matrices, une information de positionnement de matrice dans cet alvéole, une information d'orientation de matrice dans cet alvéole et une information de code de microcomposant, ainsi qu'un moyen de visualisation relié aux moyens logiques de commande, et par le fait que ces moyens logiques de commande réagissent à chaque bloc d'informations défini par la mémoire de données d'instructions en mettant le plateau circulaire en position sur l'index défini, en excitant les moyens de désignation du casier contenant des matrices emplies du type de composant à placer sur le plateau, faisant visualiser au moins l'orientation requise pour positionner la matrice, ainsi que sa position dans l'un des quadrants de l'alvéole du plateau, le cas échéant, et en contrôlant le bon positionnement de la matrice sur le plateau par l'opérateur, l'ensemble étant répété après chaque actionnement de la pédale d'opérateur, ce qui permet de remplir un plateau porte-matrices avec des
matrices rangées d'une manière connue et contenant
différents microcomposants à utiliser pour une application déterminée.

11. Installation selon l'une des revendications
4 et 5, caractérisée par le fait que la machine comporte deux supports rotatifs aptes à faire tourner deux
plateaux circulaires respectifs dans un même plan et
au voisinage l'un de l'autre, l'un des plateaux étant
le porte-matrices entraîné par pas égaux à l'écartement angulaire de deux matrices adjacentes, et l'autre
un porte-substrat entraîné par pas égaux à l'écartement angulaire de deux substrats adjacents, que des
parties voisines des deux plateaux surmontent un lecteur de code côté porte-matrices, et un détecteur de
présence de substrat côté porte-substrat, que l'organe
de transfert est capable de prendre des microcomposants
côté porte-matrices pour les amener en une position
définissable côté porte-substrat, par le fait que la
machine comporte aussi une mémoire de données d'instructions apte à définir des blocs d'informations
successifs comportant chacun une information d'index
désignant un alvéole du plateau porte-matrices, une
information de position de matrice dans cet alvéole,
une information d'orientation de matrice dans cet
alvéole, une information de pas matriciel, une information de code de microcomposants, et des informations
de coordonnées de position sur le substrat, et par le
fait que les moyens logiques de commande réagissent à
chaque bloc d'informations défini par la mémoire d'instructions en faisant tourner le plateau porte-substrat
selon l'index désigné, en y contrôlant la présence
d'une matrice dans la position désignée ; avec le
code de microcomposants désigné, et dans l'orientation désignée, en déterminant ensuite des coordonnées de mouvement de l'organe de transfert entre un logement de microcomposant dans la matrice concernée et l'emplacement de substrat désigné, ces opératiotions étant répétées pour tous les blocs d'informations avec rotation du plateau porte-matrices le cas échéant, jusqu'à ce que le substrat présent en position de travail soit équipé de tous les microcomposants désignés par les blocs d'informations successifs, et l'ensemble des opérations étant ensuite répétées à nouveau après rotation d'un pas du plateau porte-substrat jusqu'à équipement complet en microcomposants de tous les substrats que porte ce plateau.

12. Installation selon l'une des revendications précédentes, caractérisée par le fait qu'elle comporte au moins une machine selon l'une des revendications 6 à 8, au moins une machine selon l'une des revendications 9 et 10, et au moins une machine selon la revendication 11.

0014119

1/4

**Fig.1**

**Fig.1A**

| MATRICES | COTE $a$ | PAS MATRICIEL $b$ | NOMBRE DE LOGEMENTS 12 | DIMENSIONS LOGEMENTS 12 |
|---|---|---|---|---|
| N° 1 | 25,4 mm | 2,54 mm | 100 | max 2mm X 2mm |
| N° 2 | 25,4 mm | 3,56 mm | 49 { boitier SOT23 / autres | 2,9 X 2,5mm / max 3mm X 3mm |
| N° 3 | 50,8 mm | 5,08 mm | 100 | max 4mm X 4mm |
| N° 4 | 50,8 mm | 7,11 mm | 49 | max 6mm X 6mm |
| N° 5 | 50,8 mm | 10,16 mm | 25 | max 9mm x 9mm |
| N° 6 | 50,8 mm | 12,7 mm | 16 | max 12mm x 12 mm |

**Fig.2**

**Fig.3**

Fig.4A

404 403

420 406

41 40

45 42 405 47

Fig.4C

420 410 40 409 401 407 402 403

405

42 41 408

Fig.4B

42 41 410 40

420

409

401

45 402 85

450 850

Fig.4

0014119

Fig.5

Fig.6

Fig. 7

Fig. 8

**Office européen des brevets**

**RAPPORT DE RECHERCHE EUROPEENNE**

0014119
Numéro de la demande
EP 80 40 0039

| Catégorie | Citation du document avec indication, en cas de besoin, des parties pertinentes | Revendication concernée |
|---|---|---|
| | **DOCUMENTS CONSIDERES COMME PERTINENTS** | |
| A | IBM TECHNICAL DISCLOSURE BULLETIN, vol. 14, no. 1, 1 juin 1971, page 167. New York, U.S.A. M.P. MAKHIJANI: "Integrated circuit chip magazine" <br><br> * Page 167 * <br><br> -- <br><br> US - A - 3 608 175 (UNION CARBIDE CORP.) <br><br> * Revendications; figure 5 * <br><br> ---- | 1,2 <br><br><br><br><br><br><br><br> 1,4,5 |

**CLASSEMENT DE LA DEMANDE (Int. Cl. ¹)**

H 05 K 13/02

**DOMAINES TECHNIQUES RECHERCHES (Int. Cl. ¹)**

H 05 K 13/02
        13/00
H 01 L 21/44

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achevement de la recherche | Examinateur |
|---|---|---|
| La Haye | 17-04-1980 | VAN REETH |

OEB Form 1503.1   06.78